# EUROPEAN PATENT SPECIFICATION

(11) **EP 4 092 760 B1**
(45) Date of publication and mention of the grant of the patent: **29.07.2026**
(21) Application number: 21174899.1
(22) Date of filing: 20.05.2021
(51) Int. Cl.: H10F 10/14, H10F 19/90, H10F 77/20

(54) **PHOTOVOLTAIC MODULE**
FOTOVOLTAIKMODUL
MODULE PHOTOVOLTAÏQUE

(43) Date of publication of application: 23.11.2022
(73) Proprietor: "International Solar Energy Research Center Konstanz", ISC Konstanz e.V., 78467 Konstanz (DE)
(72) Inventor: HALM, Andreas, 78462 Konstanz (DE); FARNEDA, Rüdiger, 78315 Radolfzell (DE); TUNE, Daniel, 78464 Konstanz (DE)
(74) Representative: Westphal, Mussgnug & Partner Patentanwälte mbB

(56) References cited:
- EP-A1- 3 598 506
- WO-A1-2020/054129
- WO-A1-2021/020465
- CN-A- 110 246 911
- KR-A- 20180 072 110

## Description

Photovoltaic modules that are formed from solar cells are a key component for the generation of renewable energy. Optimization of these modules to increase their efficiency, more specifically the electricity generated on a given area is an ongoing process which covers a variety of different aspects. On the one hand, a lot of research effort is directed at improvement of the conversion efficiency of the individual solar cells. At the same time, however, optimizing the efficient use of the available space, i.e. offering as much active area on a given solar cell and the photovoltaic module formed from such solar cell can also contribute significantly to an improvement of the efficiency that is achieved.

One known way to increase the active area of a given solar cell is the use of IBC (interdigitated back contact) solar cells. In this well-known type of solar cell, electrical contacts are present only on the back side of the solar cell, i.e. the side that faces away from the sun under standard operating conditions. Accordingly, the entire front side that faces the sun can contribute to the generation of electricity and shadowing by the electrical contacts is completely avoided. Detailed information on the structure and production of this class of solar cells can be found for example in

G. Galbiati et al., "Large area back-contact back-junction solar cells with efficiency exceeding 21%," 2012 IEEE 38th Photovoltaic Specialists Conference (PVSC) PART 2, Austin, TX, USA, 2012, pp. 1-4, doi: 10.1109/PVSC-Vol2.2012.6656700 or

R. Kopecek et al., "ZEBRA technology: low cost bifacial IBC solar cells in mass production with efficiency exceeding 23.5%," 2020 47th IEEE Photovoltaic Specialists Conference (PVSC), Calgary, AB, Canada, 2020, pp. 1008-1012, doi: 10.1109/PVSC45281.2020.9300503.)

Whereas in a naive approach one might assume at first sight that it may be possible to use the complete area of a given photovoltaic module formed from IBC solar cells directly, simply using a side-by side arrangement, this hope is destroyed quickly by reality. One important reason for this is that the considerable variation of the temperature of the solar cells, e.g. during day-night-cycles, is leading to damage and tension due to thermal and mechanical influence if the respective solar cells are arranged if their edges are in direct contact with each other. Another reason is that there is a production related variation in wafer width, so very small gaps are not achievable due to width variations.

Therefore, traditionally when combining solar cells, especially IBC solar cells, to a photovoltaic module, a cell to cell gap was used in order to avoid damage to the individual cells, thus generating electrically inactive area of the module.

One possibility to avoid a cell to cell gap in a photovoltaic module formed using IBC solar cells that is known from the state of the art, e.g. US 2018/0108796 A1 or CN 110 246 911 A, which may disclose the features of the preamble of claim 1 of this application, is arranging the respective IBC solar cells in a cascaded or shingled manner. In other words, the IBC solar cells are arranged relative to each other in a partly overlapping manner so that a first region of a back side of a first IBC solar cell is arranged on top of a first region of a front side of a second IBC solar cell and thus creates an overlap region. The electrical contact between the respective IBC solar cells is then created by placing the entire busbars of the respective first and second IBC solar cell in the overlap region and providing a busbar contact of the second IBC solar cell on the top of the second IBC solar cell to which the busbar of is connected electrically and mechanically, **e.g.** by means of an electrically conductive glue.

There are, however, two significant disadvantages of this approach: On the one hand, the need to create a contact between busbars of the respective IBC solar cells increases the minimum size of the overlap regions considerably. In other words, whereas essentially the complete area of the photovoltaic module can be used as active area, there is and has to be a considerable amount of potentially active area of the constituent IBC solar cells forming the photovoltaic module that cannot be used, because it is arranged below another IBC solar cells. Moreover, creation of the "through-contact" in the overlap region on the front side of the IBC solar cell requires additional processing steps in the manufacturing process.

On the other hand, thermal and mechanical effects affect in this arrangement directly the electrical contact between the individual IBC solar cells, which has adverse effect and ultimately increases the risk of failure of the photovoltaic module.

WO 2020/054129 A1 discloses an arrangement of solar cells which are embedded with a distance to each other in a sealing material and electrically connected via connection members arranged at the respective rear sides of the solar cells. WO 2021/020465 A1 discloses a shingled arrangement of solar cells with a bus-bar-free electrode structure. Further solar cell arrangements are known from KR 2018 0072110 A and EP 3 598 506 A1, respectively.

Accordingly, the problem addressed by the present invention is providing a photovoltaic module formed from IBC solar cells in which the constituent IBC solar cells are arranged at least partly in a cascaded or shingled way that uses the active area of the constituent IBC solar cells more efficiently and reduces adverse effects on the electric contact between the constituent IBC solar cells.

This problem is solved by a photovoltaic module with the features of claim 1. The subject matter of the corresponding dependent claims relates to specific embodiments of the invention that may be advantageous.

The photovoltaic module according to the invention comprises several serially connected IBC solar cells, wherein each IBC solar cell has an electrode structure comprising both a P-type contact electrode structure including at least one P-busbar and an N-type electrode structure including at least one N-busbar on the back side of the respective IBC solar cell, wherein at least two of the IBC solar cells are arranged relative to each other in a partly overlapping manner so that a first region of a back side of a first IBC solar cell is arranged on top of a first region of a front side of a second IBC solar cell and thus creates an overlap region.

It should be noted that whereas continuous busbars are used more frequently and are preferred in some embodiments, the term busbar as used in this description includes also pseudo busbars, i.e. busbars that are not continuous but may be interrupted between finger contacts.

According to the invention, at least sections of both the at least one P-busbar and the at least one N-busbar of the electrode structure of said first IBC solar cell are located outside of the overlap region.

Providing sections of the busbars that are located outside of the overlap region not only allows for a reduction of the size of the overlap region, thus making use of a larger part of the active surface of each constituent IBC solar cell, but also allows for creating the electrical contact between the first IBC solar cell and the second IBC solar cell via an electric connection between their respective busbars in a readily accessible region at the back side of the solar cells, which is more simple to create from a processing point of view compared to an electrical contact in the overlap region.

Preferably, said P-type contact electrode structure and said N-type contact electrode structure each comprise substructures that are parallel to each other. This is especially the case if the respective P-type contact electrode structure and the respective N-type contact electrode structure are comb-shaped, wherein the parallel substructures form the teeth of the comb and the busbar or pseudo-busbar forms the back of the comb.

In some variants of this embodiment, said substructures of the P-type contact electrode structure that are parallel to each other and said substructures of the N-type contact electrode substructure that are parallel to each other are configured in an at least partly interdigitated pattern on the back side of the respective IBC solar cell, i.e. at least some of the teeth forming the P-type contact electrode structure are arranged adjacent and parallel to at least some of the teeth forming the N-type contact electrode structure and vice versa in the case of a partly interdigitated pattern, and all of the teeth forming the P-type contact electrode structure are arranged adjacent and parallel to teeth forming the N-type contact electrode structure and vice versa in the case of a completely interdigitated pattern.

Preferably, the entire electrode structure of the first IBC solar cell is located completely outside of the overlap region. In this way, not only the remaining overlap region is reduced further, but adverse mechanical effects and mechanical stress on the electrode structure of the IBC solar cell are also avoided.

According to the invention, the electrical contacts that form the serial connection between the first IBC solar cell and the second IBC solar cell are located completely on or adjacent to the back side of the first IBC solar cell and the second IBC solar cell. This allows for an easy creation of these electrical contacts during production of the solar cell module.

In some embodiments, the electrical contacts that form the serial connection between the first IBC solar cell and the second IBC solar cell also provide the mechanical connection between the first IBC solar cell and the second IBC solar cell, thus simplifying the production process.

One possibility to create the electrical contacts that form the serial connection between the first IBC solar cell and the second IBC solar is forming them by metal bands, e.g. flat copper wire referred to as "ribbon" with an optional thin (e.g. 5 to 35 micrometer thick) coating (e.g. SnPb solder). Preferred ribbon dimensions are a width between 2 mm and 0.4 mm, and a thickness between 0.3mm and 0.1 mm. Another possibility is the use of round wires, preferably with diameters between 2 mm and 0.1 mm as core material, also with an optional thin coating as described above.

Metal bands are well suited for this purpose not only because of their conductivity, but also because their typical mechanical properties are well suited to withstand the mechanical stress that is imposed on them when the photovoltaic module undergoes thermal cycles, e.g. induced by the temperature difference between noon and night on a clear, sunny day, therefore this choice of material for the formation of the electrical contact is also well suited to provide the mechanical connection between the individual IBC solar cells that form the photovoltaic module.

An alternative possibility for creating the electrical contacts that form the serial connection between the first IBC solar cell and the second IBC solar is the application of a foil that is locally conductive on the back side of the IBC solar cells forming the photovoltaic module, e.g. by gluing it to said back side, so that the locally conductive foil forms the back side of the photovoltaic module. For example, such a foil can be a bare Cu foil or a layered system comprising e.g. a front isolation layer (oriented towards the cell side) or rear polymer layers to seal the PV module.

The electrical contact can e.g. be formed by local connections between cell and foil realized e.g. by conductive adhesive gluing, solder paste or laser welding.

According to the invention, at least one of the at least one P-busbar and the at least one N-busbar runs orthogonal to an edge of the second IBC solar cell that defines the border of the overlap region. In this way, additional freedom with respect to the choice of the overlap region is obtained.

According to a preferred embodiment, at least both the P-busbars and the N-busbars of the electrode structures of both the respective first IBC solar cell and the respective second IBC solar cell are arranged in such a way on the back side of these IBC solar cells that inverting a respective first or second IBC solar cell by performing a rotation by 180° around an axis that is located in the center of the plane defined by the respective wafer on which the respective IBC solar cell is formed, said axis furthermore being orthogonal to said plane, moves the P-busbars into places in space that were previously occupied by N-busbars and vice versa. In this geometry, the connection between several IBC solar cells forming the photovoltaic module can be made very simple, especially by arranging the first IBC solar cell in an inverted orientation relative to the second IBC solar cell, i.e. rotated by 180° relative to the above-mentioned axis.

Whereas naturally the direction in which the fronts respective IBC solar cells are facing remains identical, the above-defined geometry of the busbars leads to a situation in which the P-busbars of the first IBC solar cell are arranged in line with the N-busbars of the second IBC solar cell, in line with the P-busbars of the third IBC solar cell etc., which allows for easy connection of busbars that need to be connected in order to achieve a serial connection between the IBC solar cells of the photovoltaic module.

As shown below in detail for a specific example of a photovoltaic module, the layout of the electrical contacts of the photovoltaic module can be made especially simple if the electrode structure of each of the first IBC solar cell and the second IBC solar cell, respectively, comprises at least two pairs of busbars, each pair of busbars being formed by a P-busbar and an N-busbar running essentially parallel to each other and at a smaller distance from each other than from any other P-busbar or N-busbar belonging to said electrode structure.

A very simple layout is achieved if the electrode structure of each of the first IBC solar cell and the second IBC solar cell, respectively, comprises exactly two pairs of busbars.

According to another embodiment of the invention, the photovoltaic module can comprise at least one IBC solar cell that has been cut in order to reduce the maximum current and thus reduce losses, so that it comprises a cut edge. In this embodiment, the IBC solar cells are arranged in such an orientation that at least one of the cut edges forms a border of the first region of the second IBC solar cell, so that it is shadowed by the first IBC solar cell. In this arrangement, the covered areas are areas that have a reduced output anyway due to losses induced by the cutting in the vicinity of the cut edge.

Photovoltaic modules according to this invention can be formed by a single string of photovoltaic cells. Preferably, however, they are grouped to form arrangements of several strings of photovoltaic cells in an advantageous way. Such a preferred arrangement may comprise at least a first string of photovoltaic cells arranged according to the invention and a second string of photovoltaic cells arranged according to the invention. At least the first string of photovoltaic cells and the second string of photovoltaic cells are arranged relative to each other in a partly overlapping manner so that a first region of a back side of the first string of photovoltaic cells is arranged on top of a first region of a front side of the second string of photovoltaic cells and thus creates an overlap region. In this way, the previous necessity of providing a gap between adjacent strings of photovoltaic cells, which existed for the same reasons as discussed above in the context of gaps between individual solar cells of a string of photovoltaic cells, is also eliminated.

It should be noted that such an arrangement is realized preferably with specific P-type and N-type electrode structures, in which the P-busbars and the N-busbars run orthogonal to an edge of the second IBC solar cell that defines the border of the overlap region, because the shingled structure of the respective string of photovoltaic cells necessitates a slight shift of the photovoltaic modules relative to each other.

Next, the invention is explained in more in detail based on figures that show embodiments thereof. More specifically, the figures show:
- Fig.1:: a first embodiment of a photovoltaic module, shown for the back side
- Fig.2:: a side view of the photovoltaic module of Fig. 1,
- Fig.3:: a second embodiment of a photovoltaic module, shown from the back side,
- Fig.4:: a side view of the photovoltaic module of Fig. 3,
- Fig.5:: a photovoltaic module arrangement comprising at least a first string of photovoltaic cells arranged to form a photovoltaic module according to an embodiment of the invention and a second string of photovoltaic cells arranged to form a photovoltaic module according to an embodiment of the invention, and
- Fig.6:: a schematic simplified representation of an electrode structure of a photovoltaic cell.

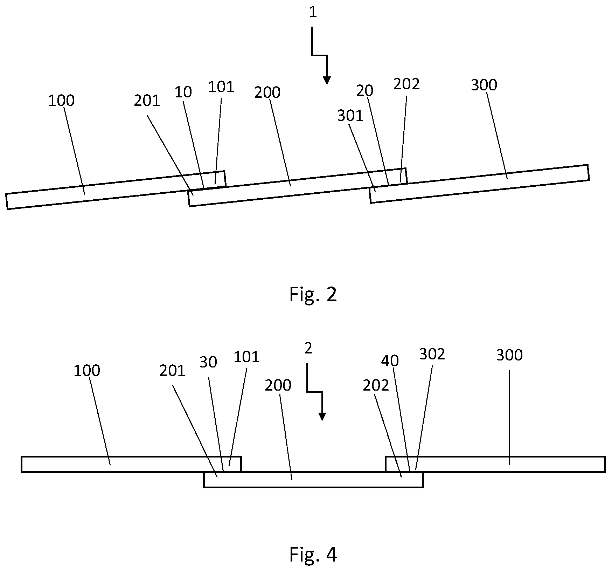

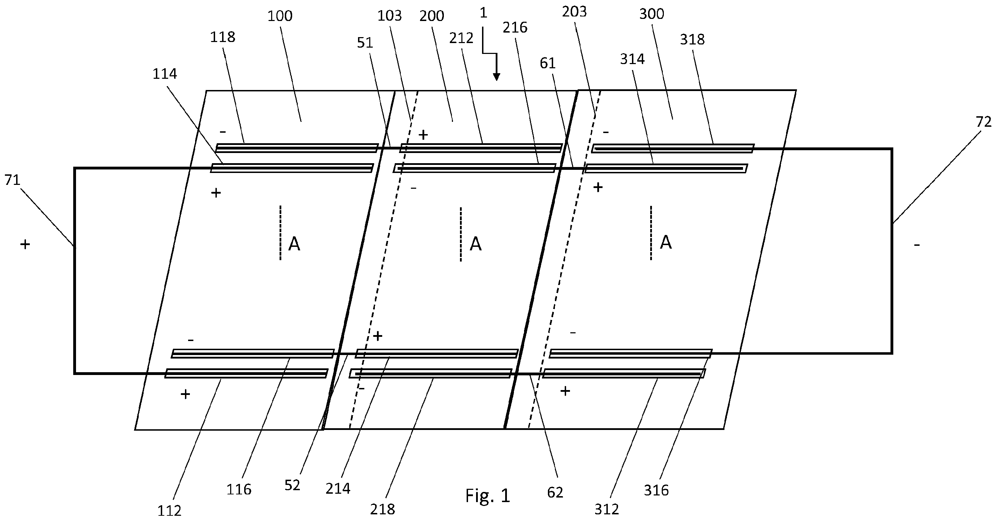

Figures 1 and 2 show a back view and a side view, respectively, of a photovoltaic module 1 which is formed by a first IBC solar cell 100, a second IBC solar cell 200 and a third IBC solar cell 300. The first IBC solar cell 100, the second solar cell 200 and the third solar cell 300 form a string of solar cells, which is the most simple structure of a photovoltaic module. This number of constituent solar cells is chosen for illustrative purpose only, the principles explained below can be extended easily by the person skilled in the art based on the provided information to photovoltaic modules comprising more constituent solar cells and/or more strings of solar cells.

Each of the IBC solar cells 100,200,300 comprises an electrode structure that is arranged on the back side of the IBC solar cells 100,200,300, i.e. on the side that during operation of the photovoltaic module 1 is facing away from the sun. The electrode structures each comprise both P-type electrode structures and N-type electrode structures. In this example, the P-type electrode structure comprises two P-busbars 112, 114,212,214,312,314, from which conducting fingers that are not shown in the figure for the sake of clarity extend along the back side of the IBC solar cell in orthogonal direction to the P-busbars 112,114,212,214,312,314.

In other words, these fingers form substructures of the P-type electrode structure that are parallel to each other. Together with the respective P-busbar 112,114,212,214,312,314 to which they are connected, they can form e.g. a comb-shaped structure, wherein the form fingers form the teeth of the comb and the respective P-busbar 112,114,212,214,312,314 or, in other embodiments, P-pseudo-busbar forms the back of the comb.

Likewise, in this example the N-type electrode structure comprises two N-busbars 116,118,216,218,316,318, from which conducting fingers that are also not shown in the figures for the sake of clarity extend along the back side of the IBC solar cell 100,200,300 in in orthogonal direction to the N-busbars 116,118,216,218,316,318. Just as in the case of the P-type electrode structure, these fingers form substructures of the N-type electrode structure that are parallel to each other. Together with the respective N-busbar 116,118,216,218,316,318 to which they are connected, they can form **e.g.** a comb-shaped structure, wherein the form fingers form the teeth of the comb and the respective N-busbar 116,118,216,218,316,318 or, in other embodiments, N-pseudo-busbar forms the back of the comb.

At least some parts of the respective conducting fingers of a P-type electrode structure run parallel and adjacent to at least some parts of the respective conducting fingers of an **N-**type electrode structure and can form the interdigitated pattern that is encountered in most IBC solar cells.

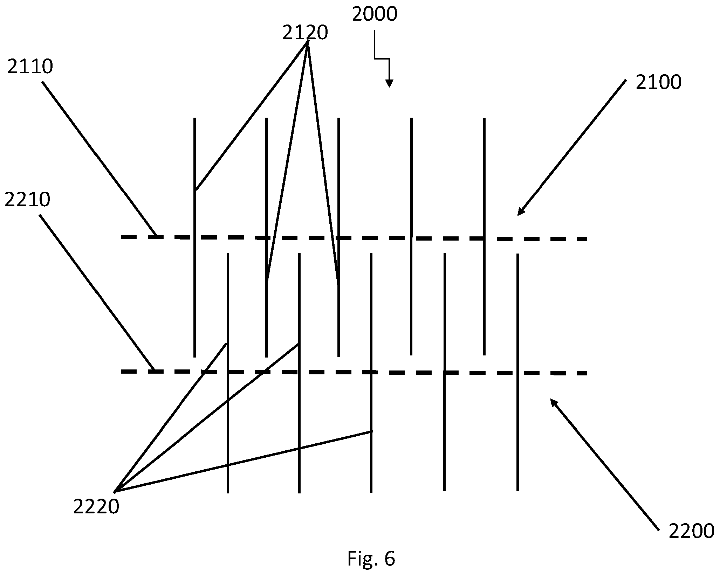

In order to clarify this terminology, in Fig. 6 a schematic and simplified representation of a complete electrode structure 2000 of a photovoltaic IBC solar cell is shown.

The electrode structure 2000 comprises a P-type contact electrode structure 2100 and an N-type contact electrode structure 2200. The P-type contact electrode structure 2100 comprises a P-busbar 2110 and a plurality of fingers 2120 extending orthogonally form the P-busbar 2110. Likewise, the N-type contact electrode structure 2200 comprises an N-busbar 2120 and a plurality of fingers 2220 extending orthogonally form the **N-**busbar 2210.

Accordingly, both the P-type contact electrode structure 2100 and the N-type contact electrode structure 2200 each comprise substructures, especially the respective sets of fingers 2120 and 2220, respectively, which are parallel to each other.

More specifically, in this example the respective P-type contact electrode structure 2100 and the respective N-type contact electrode structure 2200 are comb-shaped, wherein the parallel substructures formed by the respective sets of fingers 2120,2220 form the teeth of the comb and the respective busbars 2110,2120 form the back of the comb.

Evidently, in the embodiment shown in Figure 6 said substructures of the P-type contact electrode structure 2100 that are parallel to each other (i.e. the set of fingers 2120) and said substructures of the N-type contact electrode substructure 2200 that are parallel to each other (i.e. the set of fingers 2220) are configured in a partly interdigitated pattern on the back side of the respective IBC solar cell, i.e. at least some of the teeth of the comb represented by the fingers 2120 of the P-type contact electrode structure 2100 are arranged adjacent and parallel to at least some of the teeth of the comb represented by the fingers 2220 of the N-type contact electrode structure 2200 and vice versa.

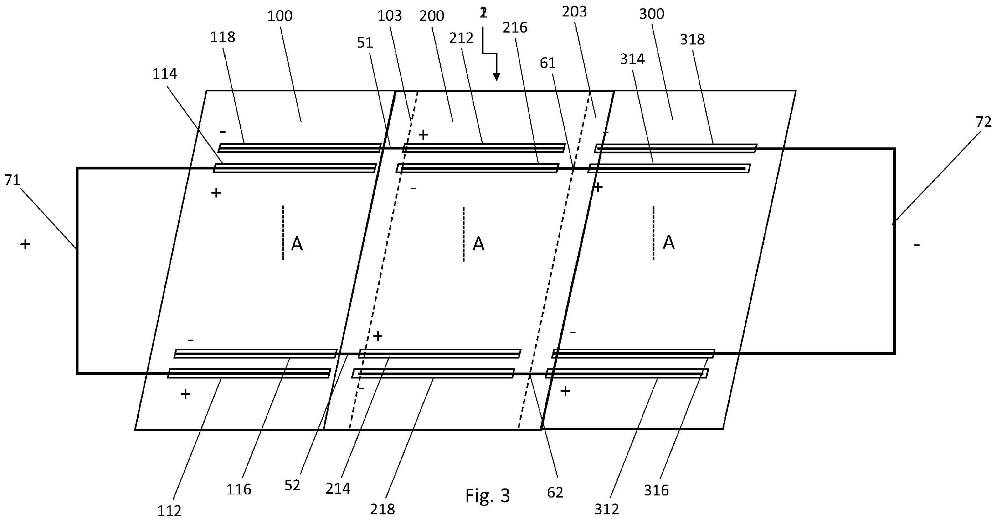

As becomes evident especially in the side view shown in Figure 2, the IBC solar cells 100,200,300 are arranged in a shingled way, i.e. in a partly overlapping manner so that a first region 101 of the back side of the first IBC solar cell 100 is arranged on top of a first region 201 of the front side of the second IBC solar cell 200 and thus creates an overlap region 10. Likewise, a first region 202 of the back side of the second IBC solar cell 200 is arranged on top of a first region 301 of the front side of the third IBC solar cell 300, thus creating an overlap region 20. In order to illustrate this in Figure 1, the position of the edges 103,203,303 of the IBC solar cells 100,200,303 that are not visible in the perspective of Figure 1 or Figure 3, respectively, are shown as dotted lines in these figures. As a consequence, edge to edge contact of the respective IBC solar cells 100,200,300 is avoided even if thermal expansion occurs. It should be noted that the size of the overlap regions is exaggerated in the Figures; in practice a small overlap of few mm is sufficient.

As illustrated in Figure 1, the electrical and mechanical connection between the IBC solar cells 100,200,300 of the photovoltaic module 1 is obtained by metal bands 51,52,61,62 that are arranged on respective bus bars. These metal bands 51,52,61,62 possess not only good electric conductivity, but also the strength and elasticity required for the mechanical connection of the IBC solar cells 100,200,300 to each other. Specifically, the metal bands 51,52,61,62 can be fixed to the back side of the IBC solar cells 100,200,300 in the region of the respective busbars, but not or only partly in the transition region between the neighboring IBC solar cells 100,200,300, which then allows for some play or slack of the metal band in the transition region to accommodate geometric changes induced by expansion and/or contraction under thermal load. It should be noted that the width of the metal bands 51,52,61,62 is chosen smaller than the width of the busbars in the figures only in order to enable showing both the busbar and the metal band.

Essentially, this is also the reason why no figure is presented that shows the embodiment using a back side foil to create the electric and mechanical connections - in this case, the foil covers all other structures on the back side of the photovoltaic module in the back views, and it is not recognizable in the side view.

Returning to Figures 1 and **2****,** as a serial connection between the IBC solar cells 100,200, 300 is desired, the N-busbars 116,118 of the first IBC solar cell 100 are connected to the P-busbars 212,214 of the second IBC solar cell 200 and the **N-**busbars 216,218 of the second IBC solar cell 200 are connected to the P-busbars 312,314 of the third IBC solar cell 300. The P-busbars 112,114 of the first IBC solar cell 100 are connected to the positive connector 71 of the photovoltaic module 1, whereas the N-busbars of the third IBC solar cell 300 are connected to the negative connector 72 of the photovoltaic module 1.

In this example, the respective electrode structures are arranged in such a way on the back side of the IBC solar cells 100,200,300 that two pairs of busbars 112,116;114,118;212,216; 214,218;312,316,314,318 are formed, each pair of busbars being formed by a P-busbar and an N-busbar running essentially parallel to each other and at a smaller distance from each other than from any other P-busbar or N-busbar belonging to said electrode structure.

Moreover, the position of the busbars in the displayed electrode structure is chosen in such a way that inverting an IBC solar cell 100,200,300 by performing a rotation by 180° around an axis A that is located in the center of the plane defined by the respective wafer on which the respective IBC solar cell 100,200,300 is formed, which axis A is furthermore orthogonal to said plane, moves the P-busbars into places in space that were previously occupied by N-busbars and vice versa. As a consequence of this choice, all three IBC solar cells 100,200,300 can be produced with the identical layout of the electrode structure on their back side, as the need to align different types of busbars of neighboring IBC solar cells, e.g. N-busbars of IBC solar cell 100 and P-busbars of IBC solar cell 200 and vice versa in the photovoltaic module 1 can simply be met by arranging every second IBC solar cell of the photovoltaic module 1 in the above-described inverted position.

Figures 3 and 4 show a back view and a side view, respectively, of a string of photovoltaic cells that forms a most simple photovoltaic module 2 which is obtained by a different arrangement of the first IBC solar cell 100, the second IBC solar cell 200 and the third IBC solar cell 300, but with quite similar electrical and mechanical connections. As the IBC solar cells 100,200,300 and the basic electrical and mechanical connection scheme are identical to the ones used to form the above-described photovoltaic module 1, the same reference numerals are used and a repetition of the detailed description of the IBC solar cells 100,200,300 is not necessary but can be replaced by reference to the corresponding explanations in the context of Figures 1 and 2.

However, as can be seen in the side view of Figure 4, and recognized when analyzing the broken lines that are used to indicate the overlap between the IBC solar cells 100,200,300 in Figure 3, in the photovoltaic module 20 the IBC solar cells 100,200,300 are arranged in two planes rather than in a shingled way, as was the case in the photovoltaic module 10 described above. Accordingly, whereas the overlap region 30 is once again formed by a first region 101 of the back side of the first IBC solar cell 100 being arranged on top of a first region 201 of the front side of the second IBC solar cell 200, this time a first region 302 of the back side of the third IBC solar cell 300 is arranged on top of a second region 202 of the front side of the second IBC solar cell 300, thus creating an overlap region 40.

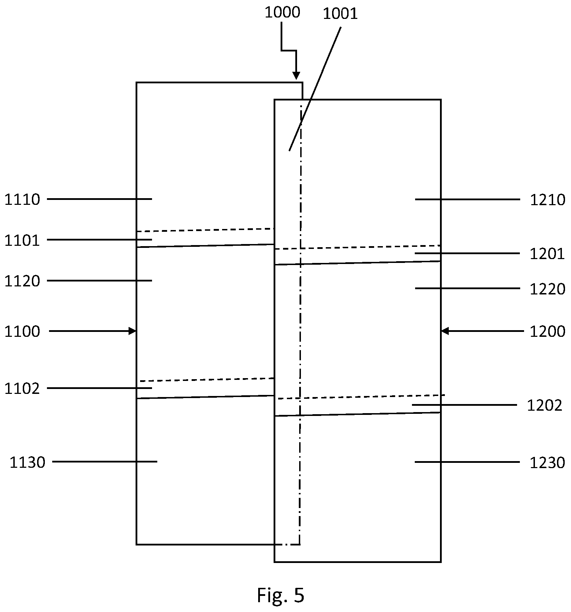

Fig. 5 shows a photovoltaic module arrangement 1000 that is formed as an arrangement comprising a first string of photovoltaic cells 1200 which essentially corresponds to the most simple photovoltaic module according to an embodiment of the invention with solar cells 1210,1220,1230 that are arranged in a shingled way, so that overlap regions 1201,1202 are created and a second string of photovoltaic cells 1100 which essentially corresponds to the most simple photovoltaic module according to an embodiment of the invention with solar cells 1110,1120,1130 that are arranged in a shingled way. The photovoltaic module arrangement 1000 of this example thus corresponds to a photovoltaic module that is put together from two more simple photovoltaic (sub-) modules formed by strings of photovoltaic cells 1100,1200.

The first string of photovoltaic cells 1200 and the second string of photovoltaic cells 1100 are arranged relative to each other in a partly overlapping manner so that a first region of a back side of the first photovoltaic module 1200 is arranged on top of a first region of a front side of the second string of photovoltaic cells 1100 and thus creates an overlap region 1001. In this way, it is possible to eliminate the need to leave gaps between the individual strings of photovoltaic cells as well.

### Reference Numerals

- 1,2: photovoltaic module
- 10,20,30,40: overlap region
- 51,52,61,62: metal band
- 71: positive connector
- 72: negative connector
- 100,200,300,1110,1120,1130, 1210,1220,1230: IBC solar cell
- 101,102,201,202,301,302: region
- 103,203,303: edge
- 112,114,212,214,312,314: P-busbar
- 116,118,216,218,316,318: N-busbar
- 1000: photovoltaic module arrangement
- 1001,1101,1102,1201,1202: overlap region
- 1100,1200: string of photovoltaic cells
- 2000: electrode structure
- 2100: P-type contact electrode structure
- 2110: P-busbar
- 2120: fingers
- 2200: N-type contact electrode structure
- 2210: N-busbar
- 2220: fingers

- A: axis

## Claims

1. A photovoltaic module (1,2) comprising several serially connected IBC solar cells (100,200,300), wherein each IBC solar cell (100,200,300) has an electrode structure comprising both a P-type contact electrode structure including at least one P-busbar (112,114,212, 214,312,314) and an N-type contact electrode structure including at least one N-busbar (116,118,216,218,316,318), on the back side of the respective IBC solar cell (100,200,300),
wherein at least two of the IBC solar cells (100,200,300) are arranged relative to each other in a partly overlapping manner so that a first region of a back side of a first IBC solar cell (100) is arranged on top of a first region of a front side of a second IBC solar cell (200) and thus creates an overlap region (10,20)
wherein at least sections of both the at least one P-busbar (112,114,212,214,312,314) and the at least one N-busbar (116,118,216,218,316,318) of the electrode structure of said first IBC solar cell (100) are located outside of the overlap region (10,30) and that the electrical contacts that form the serial connection between the first IBC solar cell (100) and the second IBC solar cell (200) are located completely on or adjacent to the back side of the first IBC solar cell (100) and the second solar cell (200), **characterizedinthat**
at least one of the at least one P-busbar (112,114,212, 214,312,314) and the at least one N-busbar (116,118,216, 218,316,318) runs orthogonal to an edge of the second IBC solar cell (200) that defines the border of the overlap region (10,30).

2. The photovoltaic module (1,2) of claim 1,
wherein said P-type contact electrode structure and said N-type contact electrode structure each comprise substructures that are parallel to each other.

3. The photovoltaic module of claim 2, wherein said substructures of the P-type contact electrode structure that are parallel to each other and said substructures of the N-type contact electrode substructure that are parallel to each other are configured in an at least partly interdigitated pattern on the back side of the respective IBC solar cell (100,200,300).

4. The photovoltaic module (1,2) of one of claims 1 to 3,
wherein the entire electrode structure of the first IBC solar cell (100) is located completely outside of the overlap region (10,30).

5. The photovoltaic module (1,2) of one of claims 1 to 4,
wherein the electrical contacts that form the serial connection between the first IBC solar cell (100) and the second IBC solar cell (200) also provide the mechanical connection between the first IBC solar cell (100) and the second IBC solar cell (200).

6. The photovoltaic module (1,2) of one of claims 1 to 5,
wherein the electrical contacts that form the serial connection between the first IBC solar cell (100) and the second IBC solar cell (200) are formed by metal bands (51,52,61,62).

7. The photovoltaic module (1,2) of one of claims 1 to 5,
wherein the electrical contacts that form the serial connection between the first IBC solar cell (100) and the second IBC solar cell (200) are formed by a locally conductive foil.

8. The photovoltaic module (1,2) of claim 7,
wherein the locally conductive foil forms the back side of the photovoltaic module (1,2).

9. The photovoltaic module (1,2) of one of claims 1 to 8, wherein at least both the P-busbars (112,114,212,214,312, 314)and the N-busbars (116,118,216,218,316,318) of the electrode structures of both the respective first IBC solar cell (100) and the respective second IBC solar cell (200) are arranged in such a way on the back side of these IBC solar cells (100,200) that inverting a respective first or second IBC solar cell (100,200) by performing a rotation by 180° around an axis that is located in the center of the plane defined by a respective wafer on which the respective IBC solar cell (100,200) is formed, said axis furthermore being orthogonal to said plane, moves the P-busbars (112,114,212,214,312,314) into places in space that were previously occupied by N-busbars (116,118,216,218,316,318) before said rotation and vice versa.

10. The photovoltaic module (1,2) of claim 9,
wherein the first IBC solar cell (100) is inverted relative to the second IBC solar cell (200).

11. The photovoltaic module (1,2) of one of claims 1 to 10, wherein the electrode structure of each of the first IBC solar cell (100) and the second IBC solar cell (200), respectively, comprises at least two pairs of busbars (112,116;114,118;212,216;214,218;312,316;314,318), each pair of busbars being formed by a P-busbar (112,114,212, 214,312,314) and an N-busbar (116,118,216,218,316,318) running essentially parallel to each other and at a smaller distance from each other than from any other P-busbar (112,114,212,214,312,314) or N-busbar (116,118,216, 218,316,318) belonging to said electrode structure.

12. The photovoltaic module (1,2) of claim 11,
wherein the electrode structure of each of the first IBC solar cell (100) and the second IBC solar cell (200), respectively, comprises exactly two pairs of busbars (112, 116;114,118;212,216;214,218;312,316;314,318).

13. The photovoltaic module (1,2) of one of claims 1 to 12,
wherein at least one of the IBC solar cells (100,200,300) has been cut so that it comprises a cut edge, wherein the IBC solar cells (100,200,300) are arranged in such an orientation that at least one of the cut edges forms a border of the first region of the second IBC solar cell, so that it is shadowed by the first IBC solar cell.

14. A photovoltaic module arrangement (1000) comprising at least a first string of photovoltaic cells (1200) arranged as in a photovoltaic module according to one of claims 1 to 13 and a second string of photovoltaic cells (1100) arranged as in a photovoltaic module according to one of claims 1 to 13, wherein at least the first string of photovoltaic cells (1200) and the second string of photovoltaic cells (1100) are arranged relative to each other in a partly overlapping manner so that a first region of a back side of the first string of photovoltaic cells (1200) is arranged on top of a first region of a front side of the second string of photovoltaic cells (1100) and thus creates an overlap region (1001).

## Patentansprüche

1. Photovoltaikmodul (1, 2), das mehrere in Reihe geschaltete IBC-Solarzellen (100, 200, 300) aufweist, wobei jede IBC-Solarzelle (100, 200, 300) auf der Rückseite der jeweiligen IBC-Solarzelle (100, 200, 300) eine Elektrodenstruktur, die sowohl eine Kontaktelektrodenstruktur vom Typ P mit zumindest einer P-Stromschiene (112, 114, 212, 214, 312, 314) und eine Kontaktelektrodenstruktur vom Typ N mit zumindest einer N-Stromschiene (116, 118, 216, 218, 316, 318) aufweist, besitzt, wobei zumindest zwei der IBC-Solarzellen (100, 200, 300) relativ zueinander auf eine teilweise überlappende Weise angeordnet sind, so dass eine erste Region einer Rückseite einer ersten IBC-Solarzelle (100) oben auf einer ersten Region einer Vorderseite einer zweiten IBC-Solarzelle (200) angeordnet ist und somit eine Überlappungsregion (10, 20) erzeugt, wobei sich zumindest Abschnitte von sowohl der zumindest einen P-Stromschiene (112, 114, 212, 214, 312, 314) als auch der zumindest einen N-Stromschiene (116, 118, 216, 218, 316, 318) der Elektrodenstruktur der ersten IBC-Solarzelle (100) außerhalb der Überlappungsregion (10, 30) befinden und dass sich die elektrischen Kontakte, die die Reihenschaltung zwischen der ersten IBC-Solarzelle (100) und der zweiten IBC-Solarzelle (200) bilden, vollständig auf oder benachbart zu der Rückseite der ersten IBC-Solarzelle (100) und der zweiten Solarzelle (200) befinden, **dadurch gekennzeichnet,**
**dass** zumindest eine der zumindest einen P-Stromschiene (112, 114, 212, 214, 312, 314) und der zumindest einen N-Stromschiene (116, 118, 216, 218, 316, 318) senkrecht zu einer Kante der zweiten IBC-Solarzelle (200), die die Grenze der Überlappungsregion (10, 30) definiert, verläuft.

2. Photovoltaikmodul (1, 2) nach Anspruch 1,
wobei die Kontaktelektrodenstruktur vom Typ P und die Kontaktelektrodenstruktur vom Typ N jeweils zueinander parallele Unterstrukturen aufweisen.

3. Photovoltaikmodul nach Anspruch 2, wobei die zueinander parallelen Unterstrukturen der Kontaktelektrodenstruktur vom Typ P und die zueinander parallelen Unterstrukturen der Kontaktelektrodenstruktur vom Typ N in einem zumindest teilweise ineinandergreifenden Muster auf der Rückseite der jeweiligen IBC-Solarzelle (100, 200, 300) gestaltet sind.

4. Photovoltaikmodul (1, 2) nach einem der Ansprüche 1 bis 3, wobei sich die gesamte Elektrodenstruktur der ersten IBC-Solarzelle (100) vollständig außerhalb der Überlappungsregion (10, 30) befindet.

5. Photovoltaikmodul (1, 2) nach einem der Ansprüche 1 bis 4, wobei die elektrischen Kontakte, die die Reihenschaltung zwischen der ersten IBC-Solarzelle (100) und der zweiten IBC-Solarzelle (200) bilden, auch die mechanische Verbindung zwischen der ersten IBC-Solarzelle (100) und der zweiten IBC-Solarzelle (200) herstellen.

6. Photovoltaikmodul (1, 2) nach einem der Ansprüche 1 bis 5, wobei die elektrischen Kontakte, die die Reihenschaltung zwischen der ersten IBC-Solarzelle (100) und der zweiten IBC-Solarzelle (200) bilden, durch Metallbänder (51, 52, 61, 62) gebildet sind.

7. Photovoltaikmodul (1, 2) nach einem der Ansprüche 1 bis 5, wobei die elektrischen Kontakte, die die Reihenschaltung zwischen der ersten IBC-Solarzelle (100) und der zweiten IBC-Solarzelle (200) bilden, durch eine lokal leitfähige Folie gebildet sind.

8. Photovoltaikmodul (1, 2) nach Anspruch 7,
wobei die lokal leitfähige Folie die Rückseite des Photovoltaikmoduls (1, 2) bildet.

9. Photovoltaikmodul (1, 2) nach einem der Ansprüche 1 bis 8, wobei zumindest sowohl die P-Stromschienen (112, 114, 212, 214, 312, 314) als auch die N-Stromschienen (116, 118, 216, 218, 316, 318) der Elektrodenstrukturen sowohl der jeweiligen ersten IBC-Solarzelle (100) als auch der jeweiligen zweiten IBC-Solarzelle (200) derart auf der Rückseite dieser IBC-Solarzellen (100, 200) angeordnet sind, dass ein Umdrehen einer jeweiligen ersten oder zweiten IBC-Solarzelle (100, 200) durch Durchführen einer Drehung um 180° um eine Achse, die sich im Zentrum der durch einen jeweiligen Wafer, auf dem die jeweilige IBC-Solarzelle (100, 200) gebildet ist, definierten Ebene befindet, wobei die Achse darüber hinaus senkrecht zu dieser Ebene verläuft, die P-Stromschienen (112, 114, 212, 214, 312, 314) an Stellen im Raum, die vor der Drehung von N- Stromschienen (116, 118, 216, 218, 316, 318) eingenommen wurden, bewegt, und umgekehrt.

10. Photovoltaikmodul (1, 2) nach Anspruch 9,
wobei die erste IBC-Solarzelle (100) relativ zu der zweiten IBC-Solarzelle (200) umgedreht angeordnet ist.

11. Photovoltaikmodul (1, 2) nach einem der Ansprüche 1 bis 10, wobei die Elektrodenstruktur einer jeden von der ersten IBC-Solarzelle (100) und der zweiten IBC-Solarzelle (200) jeweils zumindest zwei Paare von Stromschienen (112, 116; 114, 118; 212, 216; 214, 218; 312, 316; 314, 318), aufweist, wobei jedes Paar von Stromschienen durch eine P-Stromschiene (112, 114, 212, 214, 312, 314) und eine N-Stromschiene (116, 118, 216, 218, 316, 318) gebildet wird, die im Wesentlichen parallel zueinander und in einem geringeren Abstand voneinander verlaufen als von jeder anderen P-Stromschiene (112, 114, 212, 214, 312, 314) oder N-Stromschiene (116, 118, 216, 218, 316, 318), die zu der Elektrodenanordnung gehört.

12. Photovoltaikmodul (1, 2) nach Anspruch 11,
wobei die Elektrodenstruktur einer jeden von der ersten IBC-Solarzelle (100) und der zweiten IBC-Solarzelle (200) jeweils genau zwei Paare von Stromschienen (112, 116; 114, 118; 212, 216; 214, 218; 312, 316; 314, 318) aufweist.

13. Photovoltaikmodul (1, 2) nach einem der Ansprüche 1 bis 12, wobei zumindest eine der IBC-Solarzellen (100, 200, 300) so geschnitten wurde, dass sie eine Schnittkante aufweist, wobei die IBC-Solarzellen (100, 200, 300) in einer solchen Ausrichtung angeordnet sind, dass zumindest eine der Schnittkanten eine Grenze der ersten Region der zweiten IBC-Solarzelle bildet, so dass sie durch die erste IBC-Solarzelle abgeschattet wird.

14. Photovoltaikmodulanordnung (1000), die zumindest eine erste Kette von Photovoltaikzellen (1200), die wie bei einem Photovoltaikmodul gemäß einem der Ansprüche 1 bis 13 angeordnet sind, und eine zweite Kette von Photovoltaikzellen (1100) aufweist, die wie bei einem Photovoltaikmodul gemäß einem der Ansprüche 1 bis 13 angeordnet sind, aufweist, wobei zumindest die erste Kette von Photovoltaikzellen (1200) und die zweite Kette von Photovoltaikzellen (1100) relativ zueinander teilweise überlappend angeordnet sind, so dass eine erste Region einer Rückseite der ersten Kette von Photovoltaikzellen (1200) oben auf einer ersten Region einer Vorderseite der zweiten Kette von Photovoltaikzellen (1100) angeordnet ist und somit einen Überlappungsbereich (1001) bildet.

## Revendications

1. Un module (1, 2) photovoltaïque comprenant plusieurs piles (100, 200, 300) solaires IBC montées en série, dans lequel chaque pile (100, 200, 300) solaire IBC a une structure d'électrode comprenant à la fois une structure d'électrode à contact de type P, incluant au moins une barre bus P (112, 114, 212, 214, 312, 314) et une structure d'électrode à contact de type N, incluant au moins une barre bus N (116, 118, 216, 218, 316, 318) du côté arrière de la pile (100, 200, 300) IBC solaire respective,
dans lequel au moins deux des piles (100, 200, 300) solaires IBC sont disposées l'une par rapport à l'autre, d'une manière à chevauchement partiel de sorte qu'une première région d'un côté arrière d'une première pile (100) solaire IBC est disposée au sommet d'une première région d'un côté avant d'une deuxième pile (200) solaire IBC et crée ainsi une région (10, 20) de chevauchement,
dans lequel au moins des parties à la fois de la au moins une barre bus P (112, 114, 212, 214, 312, 314) et de la au moins une barre bus N (116, 118, 216, 218, 316, 318) de la structure d'électrode de ladite première pile (100) solaire IBC sont disposées à l'extérieur de la région (10, 30) de chevauchement et en ce que les contacts électriques, qui forment la connexion en série entre la première pile (100) solaire IBC et la deuxième pile (200) solaire IBC, sont disposés complètement sur ou contigus au côté arrière de la première pile (100) solaire IBC et de la deuxième pile (200) solaire IBC, **caractérisé en ce que**
au moins l'une de la au moins une barre bus P (112, 114, 212, 214, 312, 314) et de la au moins une barre bus N (116, 118, 216, 218, 316, 318) court orthogonalement à un bord de la deuxième pile (200) solaire IBC, qui définit la bordure de la région (10, 30) de chevauchement.

2. Le module (1, 2) photovoltaïque de la revendication 1,
dans lequel ladite structure d'électrode de contact de type P et ladite structure d'électrode de contact de type N comprennent chacune des sous-structures, qui sont parallèles l'une à l'autre.

3. Le module photovoltaïque de la revendication 2,
dans lequel lesdites sous-structures de la structure d'électrode de contact de type P, qui sont parallèles l'une à l'autre, et lesdites sous-structures de la sous-structure d'électrode de contact de type N, qui sont parallèles l'une à l'autre, sont configurées dans une configuration au moins en partie interdigitée du côté arrière de la pile (100, 200, 300) solaire IBC respective.

4. Le module (1, 2) photovoltaïque de l'une des revendications 1 à 3,
dans lequel toute la structure d'électrode de la première pile (100) solaire IBC est disposée complètement à l'extérieur de la région (10, 30) de chevauchement.

5. Le module (1, 2) photovoltaïque de l'une des revendications 1 à 4,
dans lequel les contacts électriques, qui forment la connexion en série entre la première pile (100) solaire IBC et la deuxième pile (200) solaire IBC, donnent également l'assemblage mécanique entre la première pile (100) solaire IBC et la deuxième pile (200) solaire IBC.

6. Le module (1, 2) photovoltaïque de l'une des revendications 1 à 5,
dans lequel les contacts électriques, qui forment la connexion en série entre la première pile (100) solaire IBC et la deuxième pile (200) solaire IBC, sont formés de bandes (51, 52, 61, 62) métalliques.

7. Le module (1, 2) photovoltaïque de l'une des revendications 1 à 5,
dans lequel les contacts électriques, qui forment la connexion en série entre la première pile (100) solaire IBC et la deuxième pile (200) solaire IBC, sont formés d'une feuille conductrice localement.

8. Le module (1, 2) photovoltaïque de la revendication 7,
dans lequel la feuille conductrice localement forme le côté arrière du module (1, 2) photovoltaïque.

9. Le module (1, 2) photovoltaïque de l'une des revendications 1 à 8,
dans lequel au moins à la fois les barres bus P (112, 114, 212, 214, 312, 314) et les barres bus N (116, 118, 216, 218, 316, 318) des structures d'électrodes à la fois de la première pile (100) solaire IBC respective et de la deuxième pile (200) solaire IBC solaire respective sont disposées d'une façon telle du côté arrière de ces piles (100, 200) solaires IBC qu'en inversant une première ou une deuxième pile (100, 200) solaire IBC respective, en effectuant une rotation de 180° autour d'un axe qui passe par le centre du plan défini par une tranche respective sur laquelle la pile (100, 200) solaire IBC est formée, ledit axe s'étendant en outre orthogonal audit plan, déplace les barres bus P (112, 114, 212, 214, 312, 314) à des emplacements dans l'espace qui étaient occupés précédemment par des barres bus N (116, 118, 216, 218, 316, 318) avant ladite rotation et vice versa.

10. Le module (1, 2) photovoltaïque de la revendication 9,
dans lequel la première pile (100) solaire IBC est inversée par rapport à la deuxième pile (200) solaire IBC.

11. Le module (1, 2) photovoltaïque de l'une des revendications 1 à 10,
dans lequel la structure d'électrode de chacune de la première pile (100) solaire IBC et de la deuxième pile (200) solaire IBC, respectivement, comprend au moins deux paires de barres bus (112, 116 ; 114, 118 ; 212, 216 ; 214, 218 ; 312, 316 ; 314, 318), chaque paire de barres bus étant formée d'une barre bus P (112, 114, 212, 214, 312, 314) et d'une barre bus N (116, 118, 216, 218, 316, 318) courant sensiblement parallèlement l'une à l'autre et à une distance l'une de l'autre plus petite que de toute autre barre bus P (112, 114, 212, 214, 312, 314) ou barre bus N (116, 118, 216, 218, 316, 318) appartenant à ladite structure d'électrode.

12. Le module (1, 2) photovoltaïque de la revendication 11,
dans lequel la structure d'électrode de chacune de la première pile (100) solaire IBC et de la deuxième pile (200) solaire IBC, respectivement, comprend exactement deux paires de barres bus (112, 116 ; 114, 118 ; 212, 216 ; 214, 218 ; 312, 316 ; 314, 318).

13. Le module (1, 2) photovoltaïque de l'une des revendications 1 à 12,
dans lequel au moins l'une des piles (100, 200, 300) solaires IBC a été coupée de sorte qu'elle comprend un bord coupé, dans lequel les cellules (100, 200, 300) solaires IBC sont disposées dans une orientation telle qu'au moins l'un des bords coupés forme une bordure de la première région de la deuxième pile solaire IBC, de sorte qu'elle est mise à l'ombre par la première pile solaire IBC.

14. Un agencement (1000) de module photovoltaïque comprenant au moins une première file de piles (1200) photovoltaïques agencée comme dans un module photovoltaïque suivant l'une des revendications 1 à 13 et une deuxième file de piles (1100) photovoltaïques agencée comme dans un module photovoltaïque suivant l'une des revendications 1 à 13, dans lequel au moins la première file de piles (1200) photovoltaïques et la deuxième file de piles (1100) photovoltaïques sont disposées relativement l'une à l'autre d'une manière se chevauchant partiellement de sorte qu'une première région d'un côté arrière de la première file de piles (1200) photovoltaïques soit disposée au sommet d'une première région d'un côté avant de la deuxième file de piles (1100) photovoltaïques en créant ainsi une région (1001) de chevauchement.
